## Europäisches Patentamt

## European Patent Office

## Office européen des brevets

(11) Veröffentlichungsnummer: **0 294 611 B1**

(12)

# EUROPÄISCHE PATENTSCHRIFT

(45) Veröffentlichungstag der Patentschrift: **24.02.93**

(51) Int. Cl.5: **C25D 13/04**, G03G 13/00, B41C 1/10

(21) Anmeldenummer: **88107658.2**

(22) Anmeldetag: **13.05.88**

(54) **Verfahren zur selektiven Additivkorrektur von Fehlstellen in Kopierschichten.**

(30) Priorität: **26.05.87 DE 3717653**

(43) Veröffentlichungstag der Anmeldung:
**14.12.88 Patentblatt 88/50**

(45) Bekanntmachung des Hinweises auf die Patenterteilung:
**24.02.93 Patentblatt 93/08**

(84) Benannte Vertragsstaaten:
**DE FR GB**

(56) Entgegenhaltungen:
**EP-A- 0 155 231**
**EP-A- 0 294 610**
**DE-C- 3 305 355**

**DARWENT ACCESSION Nr. 76-64130x(34)**
**Ouestel Telesystemes (WPI) DERWENT PU-**
**BLICATIONS LTD., London & JP-A-51-078 406**
**(DAINIPPON PRINTING)**

(73) Patentinhaber: **HOECHST AKTIENGESELL-SCHAFT**
**Postfach 80 03 20**
**W-6230 Frankturt am Main 80(DE)**

(72) Erfinder: **Pliefke, Engelbert, Dr. Dipl.-Chem.**
**Drususstrasse 52**
**W-6200 Wiesbaden(DE)**
Erfinder: **Frass, Werner, Dr. Dipl.-Chem.**
**Erbsenacker 37**
**W-6200 Wiesbaden-Naurod(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Rank Xerox (UK) Business Services
(3.10/3.5x/3.0.1)

**Beschreibung**

Die Erfindung betrifft ein Verfahren zur selektiven Additivkorrektur von Fehlstellen in Kopierschichten von Druck- und Leiterplatten unter Zuhilfenahme einer wäßrigen Elektrolytlösung.

Bei der Herstellung von Offsetdruckformen oder von Photoresists (beides im weiteren Kopiermaterialien genannt) werden strahlungs(licht)empfindliche Reproduktionsschichten verwendet, die im allgemeinen vom Verbraucher oder vom industriellen Hersteller auf einen Schichtträger aufgebracht werden. Als Schichtträger für diese Kopiermaterialien werden Metalle wie Zink, Magnesium, Chrom, Kupfer, Messing, Stahl, Silicium, Aluminium oder Kombinationen dieser Metalle, Kunststofffolien, Papier oder ähnliche Materialien eingesetzt. Diese Schichtträger können ohne eine modifizierende Vorbehandlung, bevorzugt aber nach Durchführung einer Oberflächenmodifizierung wie einer mechanischen, chemischen und/oder elektrochemischen Aufrauhung, einer Oxidation und/oder einer Behandlung mit Hydrophilierungsmitteln (z. B. bei Trägern für Offsetdruckplatten) mit der strahlungsempfindlichen Reproduktionsschicht beschichtet werden. Die üblichen strahlungsempfindlichen Reproduktionsschichten enthalten neben mindestens einer strahlungsempfindlichen Verbindung meist noch ein organisches Bindemittel (z.B. Harze) und gegebenenfalls auch noch Weichmacher, Pigmente, Farbstoffe, Netzmittel, Sensibilisatoren, Haftvermittler, Indikatoren und andere übliche Hilfsmittel.

Diese Reproduktionsschichten werden nach ihrer Bestrahlung (Belichtung) entwickelt, um aus ihnen ein Bild zu erzeugen, wonach beispielsweise eine Druckform oder ein Photoresist erhalten wird. Bei elektrophotographisch arbeitenden Schichten entspricht dem Entwickeln das Entschichten. Im Rahmen der vorliegenden Erfindung sind unter dem Begriff "Reproduktionsschichten" jedoch auch solche zu verstehen, die keine strahlungsempfindliche Verbindung, aber die übrigen der aufgeführten Komponenten, d. h. insbesondere ein organisches Bindemittel, enthalten.

Es sind aus dem Stand der Technik Verfahren bekannt, bei denen eine Druckform auch ohne einen Bestrahlungs- und/oder Entwicklungsschritt und damit auch ohne einen Einsatz der sonst üblichen Reproduktionsschichten mit einem Gehalt an einer strahlungsempfindlichen Verbindung hergestellt wird.

- Aus der DE-C 24 33 448 (= US-A 4 086 853) ist der Einsatz eines elektrisch-empfindlichen Aufzeichnungsblattes mit a) einer hydrophoben Unterschicht (z. B. aus Polyester), b) einer darauf angeordneten elektrischleitenden, durch Stromeinwirkung mittels eines Stifts örtlich entfernbaren, hydrophilen Schicht (z. B. aus Aluminium) und c) einer Schicht, die nach der Stromeinwirkung von der Schicht gemäß b) ablösbar ist (z.B. aus einem Cellulosederivat, einem Weichmacher und einem Pigment) bekannt.
- Die DE-A 25 14 682 (= GB-A 1 490 732) beschreibt den Einsatz eines elektrisch-empfindlichen Aufzeichnungsmaterials mit a) einer elektrisch-leitenden, durch Stromeinwirkung nicht entfernbaren, oleophilen Schicht und b) einer darauf angeordneten, durch Stromeinwirkung mittels eines Stifts örtlich entfernbaren, oleophoben Schicht aus Silikonkautschuk.
- Weiterhin offenbart die EP-A 0 030 642 ein Verfahren zur Herstellung einer Druckform aus einem flächigen Material mit a) einer hydrophoben Trägerschicht (z. B. aus Polyester), b) einer hydrophilen, elektrisch-leitenden Zwischenschicht (z. B. aus Aluminium) und c) einer abschließenden, dielektrischen Schutzschicht (z. B. aus $Al_2O_3$) durch Elektroerosion, wobei durch Einwirkung von Elektroden sowohl die Schicht c) als auch b) entfernt werden.

Alle diese Verfahren beruhen auf einer bildmäßigen Entfernung von Schichtbestandteilen durch elektrochemischen Abbau.

Die EP-A 0 155 231 beschreibt die Elektrotauchlackierung einer Leiterplatte, die nach der Lackierung durch bildmäßige Belichtung und Entwicklung weiterverarbeitet wird.

Die EP-B 0 089 510 (= US-A 4 376 814) beschreibt das elektrochemische Abscheiden eines hydrophilen Polymers auf einer Druckplatte.

Beide Verfahren verwenden zwar die Elektrotauchlackierung zum Abscheiden von Polymeren, verwenden jedoch im Verfahren keine bildmäßige Differenzierung.

Eine bildmäßige Differenzierung wird in folgenden Veröffentlichungen beschrieben:
Die US-A 4 519 876 beschreibt ein elektrisch leitfähiges Substrat mit einer isolierenden Schicht, die nach Laserbelichtung bildmäßig entfernt werden kann. Danach folgt eine galvanische Metallabscheidung in den freien, nicht mehr geschützten Teilen.

In der JP-A 51-078 406 wird ein analoges Verfahren unter Verwendung einer Siebdruckmaske als Vorlage beschrieben, wobei ebenfalls in den nicht abgedeckten Stellen Metalle galvanisch abgeschieden werden.

Darüber hinaus sind in der Patentliteratur Verfahren bekannt, die auf elektrophotographischem Wege bzw. durch Leitfähigkeitsbilder Abscheidungen betreiben.

So beschreiben die US-A 3 106 157 und 3 085 051 Verfahren, bei denen das durch eine bildmäßige Belichtung erzeugte Leitfähigkeitsbild zur Abscheidung von Indium-bzw. Nickelatomen dient.

Die US-A 3 095 808 beschreibt die Ausnutzung der Photoleitfähigkeit nach bildmäßiger Belichtung zur Abscheidung eines Fe-, Cu-, Ni- oder Co-Salzes der Rubeanwasserstoffsäure.

In der US-A 3 106 155 wird die "Entwicklung" des durch bildmäßige Belichtung erzeugten Photoleitfähigkeitsbildes durch Polymere, wie z. B. durch Celluloseacetatphthalat, beschrieben.

Alle diese Verfahren setzen eine bildmäßige Belichtung voraus, die ein Leitfähigkeitsbild erzeugt, das durch weitere Maßnahmen fixiert wird.

Aufgabe der vorliegenden Erfindung ist es, ein Verfahren zu entwickeln, bei dem eine bildmäßige Differenzierung durch einfache Art erreicht wird.

Das erfindungsgemäße Verfahren geht aus von der aus dem Stand der Technik bekannten Elektrotauchlackierung und den in der Lithographie gebräuchlichen Verfahren zur additiven Korrektur von belichteten und entwickelten Druck- oder Leiterplatten durch stromloses, bildmäßiges Aufbringen eines Lackes oder Harzes an Stellen, die ursprünglich nicht in der Vorlage wiedergegeben wurden. Bei der Elektrotauchlackierung wird durch Anlegung von Strom in einem wasserhaltigen Elektrolytsystem entweder kathodisch oder anodisch eine ursprünglich gelöste, organische Substanz auf dem zu beschichtenden Werkstück abgeschieden. Kennzeichnend für die vorliegende Erfindung ist, daß man zwischen dem Substrat und einer nadelförmigen, gegenüber der Fehlstelle angeordneten Elektrode eine Gleichspannung anlegt und auf die Fehlstelle eine elektrisch leitfähige wäßrige Lösung einer polymeren organischen Substanz aufbringt und daß man die polymere Substanz bei einer Stromdichte im Bereich von 0,01 bis 100 A/dm$^2$ an der Fehlstelle abscheidet.

Eine mögliche Ausführungsform dieser Erfindung besteht im einfachsten Fall in einer nadelförmigen Elektrode, umgeben von Elektrotauchlack, die in möglichst geringem Abstand über der zu korrigierenden Platte geführt wird. Durch einen kurzen Strompuls gelingt es, an bildfreien Stellen auf der Platte eine punktförmige Abscheidung eines Harzes aus dem Elektrotauchbad zu induzieren. Durch cyclische Wiederholung dieses Verfahrens lassen sich ganze (Druck-)plattenbereiche bebildern.

Auch kleine Fehler in Form von unbeschichteten Stellen in Volltönen lassen sich durch Überfahren der entsprechenden Plattenbezirke unter Stromeinwirkung ohne Schwierigkeiten korrigieren.

Die Vorteile des erfindungsgemäßen Verfahrens liegen darin, daß z. B. bei der Ausbesserung von Fehlern in Volltonbereichen die Abscheidung nur in den unbeschichteten Stellen erfolgt, da nur dort eine Leitfähigkeit gegeben ist. Etwaige Lackreste auf schon beschichteten Teilen werden nicht ausgehärtet und lassen sich durch einfaches Spülen mit Wasser entfernen.

Ein weiterer Vorteil des erfindungsgemäßen Verfahrens besteht darin, daß es gelingt, mit wäßrigen, vorzugsweise lösemittelfreien, Lösungen additiv zu korrigieren, ohne eventuell vorher vorhandene Reproduktionsschichtteile anzulösen.

Durch geeignete Auswahl der abgeschiedenen organischen Verbindungen kann die Druckauflagebeständigkeit der Additivkorrekturstellen entscheidend verbessert werden, da es durch das erfindungsgemäße Verfahren gelingt, die Schicht extrem gut zu verankern.

Im Gegensatz zu der als Stand der Technik zitierten bildmäßigen Metallabscheidung wird durch das erfindungsgemäße Verfahren der Additivkorrektur mit einer organischen Verbindung schon bei sehr geringen Ladungsmengen eine geschlossene Schicht erreicht, was eine Abscheidung schon mittels einer batteriebetriebenen Einheit ermöglicht.

Nach dem erfindungsgemäßen Verfahren ist es also möglich, aus wäßrigen Lösungen, die kein organisches Lösemittel oder andere größere Mengen an umweltbelastenden Hilfsstoffen enthalten müssen, verschiedene Arten von Harzen bildmäßig abzuscheiden.

Die Konzentration der wäßrigen Lösung kann zwischen 0,1 Gew.-%, insbesondere 1 Gew.-% und der jeweiligen Sättigungskonzentration der dissoziierten Verbindung liegen, im allgemeinen sind bereits Konzentrationen bis zu 20 Gew.-% ausreichend. Wenn die Konzentration des wäßrigen Elektrolyten unter 0,1 Gew.-% liegt, dann ist meistens die Leitfähigkeit der Lösung zu niedrig, so daß die resultierende Stromdichte zu gering wird, um eine genügend rasch ablaufende Additivkorrektur zu ermöglichen. Die Temperatur des wäßrigen Elektrolyten kann von Raumtemperatur bis zum Siedepunkt des Elektrolytsystems reichen, bevorzugt wird jedoch eine Temperatur von 20° bis 70 °C eingehalten. Ein Durchmischen des wäßrigen Elektrolyten während der Durchführung des erfindungsgemäßen Verfahrens ist im allgemeinen nicht erforderlich. Für eine einfache Korrektur kann es auch von Vorteil sein, wenn mit einem sehr eingedickten Elektrolytsystem gearbeitet wird.

Das erfindungsgemäße Verfahren wird mit Gleichstrom, gegebenenfalls mit Modulation, durchgeführt, es kann auch gepulster Gleichstrom eingesetzt werden. Dabei liegt die Stromdichte im Bereich von 0,01 bis 100 A/dm$^2$, da sonst die Aufheizung der wäßrigen Elektrolytlösung zu stark bzw. die Abscheidungsgeschwindigkeit zu gering wird und/oder die Bilderzeugung hinsichtlich der Dauer oder der Qualität negativ beeinflußt werden kann. Die Stromdichte steigt zu Beginn der elektrochemischen Additivkorrektur an, verbleibt eine gewisse Zeit auf einer Höhe und fällt gegen Ende der Behandlung wieder stark ab.

Während der elektrochemischen Additivkorrektur wird bei der kathodischen Abscheidung an der Kathode Wasserstoff durch Entladung von $H^+(H_3O^+)$-Ionen freigesetzt. Es wird angenommen, daß dadurch der pH-Wert lokal stark ansteigt und die bildmäßig differenzierende Abscheidung bewirkt. Analog findet bei der anodischen, bildmäßigen Elektrotauchlackierung die Ausfällung durch ein Absinken des pH-Wertes statt.

Unter dem Begriff "nadelförmig ausgebildete Elektrode" ist ein länglicher Körper aus einem möglichst inerten (d. h. sich nicht während des erfindungsgemäßen Verfahrens abbauenden) Material wie Edelstahl, Graphit, Gold oder Platin zu verstehen, der eine möglichst kleine Spitze aufweist, um eine möglichst gute Auflösung und die Additivkorrektur feinster Elemente zu ermöglichen. Diese Elektrode wird in möglichst geringem Abstand über das zu bebildernde flächige Material geführt.

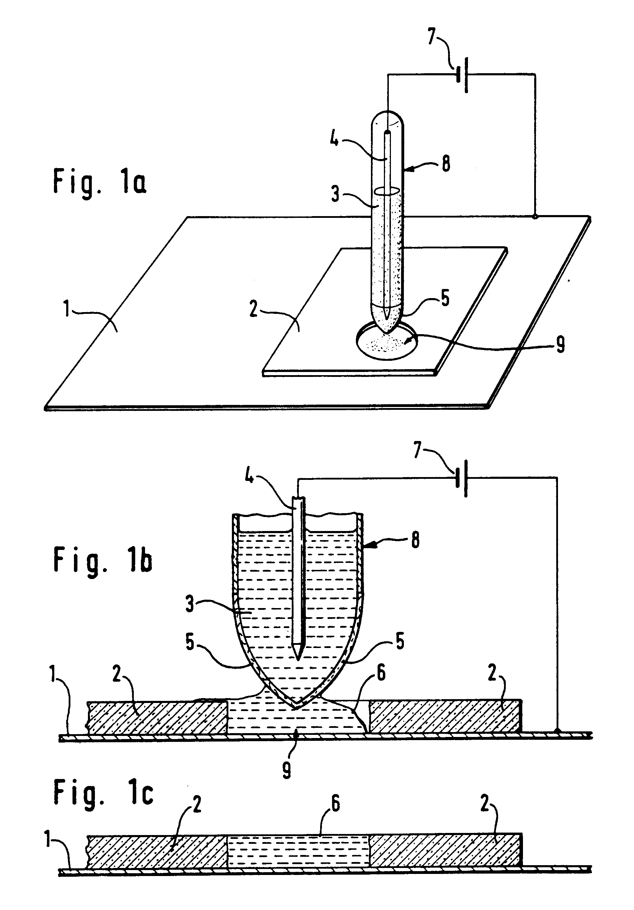

In der Figur 1a ist eine mögliche Ausführungsform dargestellt. Die konventionell bebilderte und entwickelte Platte 1 wird als ein Pol an eine Gleichspannungsquelle 7 geschaltet. Mit dem Korrekturstift 8, der den anderen Spannungspol darstellt, wird durch Überfahren der additiv zu korrigierenden Stelle 9 in der Kopierschicht 2 aus den Poren einer elektrisch nicht leitenden Membran 5 etwas der Elektrotauchlackierflüssigkeit 3 herausgepreßt. Durch einen kurzen Stromfluß wird über die in den Stift eingelassene Elektrode 4 selektiv an der Korrekturstelle das Elektrotauchharz abgeschieden und baut eine geschlossene Schicht 6 auf. Figur 1b ist eine vergrößerte Darstellung von Figur 1a. Figur 1b zeigt die ursprüngliche Fehlstelle nach der Korrektur.

Die wäßrige Elektrolytlösung muß im Verhältnis zum zu bebildernden Material und der nadelförmig ausgebildeten Elektrode so angeordnet sein, daß sie in Wechselwirkung mit den beiden als Elektroden wirkenden Körpern eine bildmäßige Additivkorrektur der Reproduktionsschicht bewirken und ein Strom zwischen der Platte und der Elektrode fließen kann. Zu den Reproduktionsschichten zählen im erfindungsgemäßen Verfahren nicht nur die üblichen später beschriebenen, bekannten strahlungsempfindlichen Schichten, sondern auch solche vergleichbarer Zusammensetzung, die jedoch keine strahlungsempfindliche Verbindung enthalten. Ganz allgemein sind unter Reproduktionsschichten solche Schichten zu verstehen, die eine bildmäßige Differenzierung ermöglichen.

In einer bevorzugten Ausführungsform des erfindungsgemäßen Verfahrens wird die additiv zu korrigierende Platte an den Korrekturstellen durch Aufstreichen mit der bindemittelhaltigen Elektrolytlösung kontaktiert. Dabei sollte eine Kante des flächigen Plattenmaterials mit der Stromquelle verbunden werden. Eine andere Möglichkeit der Stromzufuhr liegt in der Kontaktierung über die Materialrückseite. Der nadelförmig ausgebildete Korrekturstift sollte gegenüber dem flächigen Substrat insbesondere in einem gleichmäßigen Abstand angeordnet sein, damit eine gleichmäßige Stromdichte an jeder Stelle des zu bebildernden flächigen Materials eingestellt werden kann. Das ist z. B. durch das isolierende Membranmaterial gewährleistet. Der Vorteil des Verfahrens liegt darin, daß die Größe der Korrekturstellen durch Variation von Spannung und Zeit gesteuert werden kann.

Der erfindungsgemäß durch die Additivkorrektur erzeugte Reproduktionsschichtteil enthält in der Regel ein polymeres Bindemittel, das unter der Einwirkung des elektrischen Stroms aus der nadelförmig ausgebildeten Elektrode bildmäßig abgeschieden wird. Als unter die Erfindung fallend werden aber auch solche Abscheidungen auf der Basis eines polymeren Bindemittels verstanden, die eine strahlungsempfindliche Verbindung enthalten, bevorzugt werden sie jedoch als strahlungsempfindliche Schichten eingesetzt. Als Substratmaterialien kommen elektrischleitfähige Trägermaterialien in Frage, wozu beispielsweise solche mit Schichten von Zink, Chrom, Magnesium, Kupfer, Messing, Stahl, Silicium, Aluminium oder deren Legierungen oder Kombinationen dieser Metalle zählen. Diese können ohne eine spezielle, modifizierende Vorbehandlung mit einer geeigneten Reproduktionsschicht elektrochemisch bebildert werden, bevorzugt wird diese Bebilderung jedoch erst nach einer Oberflächenmodifizierung, wie einer mechanischen, chemischen oder elektrochemischen Aufrauhung, einer Oxidation und/oder einer Behandlung mit Hydrophilierungsmitteln (insbesondere bei Trägern für Offsetdruckplatten) durchgeführt.

Zu den besonders geeigneten Substraten zur Herstellung von Offsetdruckplatten zählen solche aus Aluminium oder einer seiner Legierungen, die beispielsweise einen Gehalt von mehr als 98,0 Gew.-%, insbesondere von mehr als 98,5 Gew.-% an Al und Anteile an Si, Fe, Ti, Cu, Zn, Mn und/oder Mg aufweisen.

Die in der Praxis sehr häufig anzutreffenden Aluminiumträgermaterialien für Druckplatten werden im allgemeinen vor Aufbringen der Reproduktionsschicht noch mechanisch (z. B. durch Bürsten und/oder mit Schleifmittel-Behandlungen), chemisch (z. B. durch Ätzmittel) oder elektrochemisch (z. B. durch Wechselstrombehandlung in wäßrigen HCl- oder $HNO_3$-Lösungen) aufgerauht. Die mittlere Rauhtiefe $R_z$ der aufgerauhten Oberfläche liegt dabei im Bereich von etwa 1 bis 15 $\mu$m, insbesondere im Bereich von 1,5 bis

10 $\mu$m. Die Rauhtiefe wird nach DIN 4768 in der Fassung vom Oktober 1970 ermittelt, die Rauhtiefe $R_z$ istdann das arithmetische Mittel aus den Einzelrauhtiefen fünf aneinandergrenzender Einzelmeßstrecken.

Vor der Aufrauhung kann eine Vorreinigung des Aluminiumbandes stattfinden; sie umfaßt beispielsweise die Behandlung mit wäßriger NaOH-Lösung mit oder ohne Entfettungsmittel und/oder Komplexbildnern, Trichlorethylen, Aceton, Methanol oder anderen handelsüblichen sogenannten Aluminiumbeizen. Der Aufrauhung oder bei mehreren Aufrauhstufen auch noch zwischen den einzelnen Stufen kann außerdem zusätzlich eine abtragende Behandlung nachgeschaltet werden, wobei insbesondere maximal 5 g/m$^2$ abgetragen werden. Als abtragend wirkende Lösungen werden im allgemeinen wäßrige Alkalihydroxidlösungen bzw. wäßrige Lösungen von alkalisch reagierenden Salzen oder wäßrige Säurelösungen auf der Basis von HNO$_3$, H$_2$SO$_4$ oder H$_3$PO$_4$ eingesetzt. Neben einer abtragenden Behandlungsstufe zwischen der Aufrauhstufe und einer gegebenenfalls nachfolgenden Anodisierstufe sind auch solche nicht-elektrochemischen Behandlungen bekannt, die im wesentlichen lediglich eine spülende und/oder reinigende Wirkung haben und beispielsweise zur Entfernung von bei der Aufrauhung gebildeten Belägen ("Schmant") oder einfach zur Entfernung von Behandlungsresten dienen; im Einsatz sind für diese Zwecke beispielsweise verdünnte wäßrige Alkalihydroxidlösungen oder Wasser.

Nach dem oder den Aufrauhverfahren kann sich dann gegebenenfalls in einer weiteren anzuwendenden Verfahrensstufe eine anodische Oxidation des Aluminiums anschließen, um beispielsweise die Abrieb- und die Haftungseigenschaften der Oberfläche des Trägermaterials zu verbessern. Zur anodischen Oxidation können die üblichen Elektrolyte wie H$_2$SO$_4$, H$_3$PO$_4$, H$_2$C$_2$O$_4$, Amidosulfonsäure, Sulfobernsteinsäure, Sulfosalicylsäure oder deren Mischungen eingesetzt werden; insbesondere werden H$_2$SO$_4$ und H$_3$PO$_4$ allein, in Mischung und/oder in einem mehrstufigen Anodisierprozeß verwendet. Die Schichtgewichte an Aluminiumoxid bewegen sich im Bereich von 1 bis 10 g/m$^2$, entsprechend einer Schichtdicke von etwa 0,3 bis 3,0 $\mu$m.

Der Stufe einer anodischen Oxidation des Trägermaterials aus Aluminium können auch eine oder mehrere Nachbehandlungsstufen nachgeschaltet werden. Dabei wird unter Nachbehandeln insbesondere eine hydrophilierende chemische oder elektrochemische Behandlung der Aluminiumoxidschicht verstanden, beispielsweise eine Tauchbehandlung des Materials in einer wäßrigen Polyvinylphosphonsäure-Lösung nach der DE-C 16 21 478 (= GB-A 1 230 447), eine Tauchbehandlung in einer wäßrigen Alkalisilikat-Lösung nach der DE-B 14 71 707 (= US-A 3 181 461) oder eine elektrochemische Behandlung (Anodisierung) in einer wäßrigen Alkalisilikat-Lösung nach der DE-A 25 32 769 (= US-A 3 902 976). Diese Nachbehandlungsstufen dienen insbesondere dazu, die bereits oftmals ausreichende Hydrophilie der Aluminiumoxidschicht noch zusätzlich zu steigern, wobei die übrigen bekannten Eigenschaften dieser Schicht mindestens erhalten bleiben.

Als strahlungs(licht)empfindliche Reproduktionsschichten sind grundsätzlich solche zu verstehen, die - in den sonst üblichen Methoden, die erfindungsgemäß jedoch nicht erforderlich sind - nach dem Bestrahlen (Belichten), gegebenenfalls mit einer nachfolgenden Entwicklung und/oder Fixierung eine bildmäßige Fläche liefern, von der gedruckt werden kann.

Zu den lichtempfindlichen Reproduktionsschichten zählen solche, wie sie z. B. in "Light-Sensitive Systems" von Jaromir Kosar, John Wiley & Sons Verlag, New York 1965, beschrieben werden: die Chromate und Dichromate enthaltenden Kolloidschichten (Kosar, Kapitel 2); die ungesättigte Verbindungen enthaltenden Schichten, in denen diese Verbindungen beim Belichten isomerisiert, umgelagert, cyclisiert oder vernetzt werden (Kosar, Kapitel 4); die photopolymerisierbare Verbindungen enthaltenden Schichten, in denen Monomere oder Präpolymere gegebenenfalls mittels eines Initiators beim Belichten polymerisieren (Kosar, Kapitel 5); und die o-Diazo-chinone wie Naphthochinondiazide, p-Diazo-chinone oder Diazoniumsalz-Kondensate enthaltenden Schichten (Kosar, Kapitel 7). Zu den geeigneten Schichten zählen auch die elektrophotographischen Schichten, d. h. solche die einen anorganischen oder organischen Photoleiter enthalten. Außer den strahlungsempfindlichen Substanzen können diese Schichten selbstverständlich noch andere Bestandteile, wie z. B. Harze, Farbstoffe oder Weichmacher, enthalten.

Die vorstehend beschriebenen strahlungsempfindliche Verbindungen enthaltenden Schichten werden im erfindungsgemäßen Verfahren - sofern sie mindestens ein Bindemittel enthalten - bevorzugt ohne Anwesenheit der strahlungsempfindlichen Verbindung eingesetzt. Insbesondere sind dann folgende lösliche organische Polymere in wäßrigen Elektrolyten geeignet: Polyamide, Polyester, Alkydharze, Polyvinylalkohol, Polyvinylpyrrolidon, Polyethylenoxid, Polyacetale, Gelatine, Celluloseether, Melamin-Formaldehydharze, Aminharze, Acrylharze und/oder Polyepoxide (z. B. auf der Basis epoxidierten Leinöls); aber auch andere elektrolytisch abscheidbare Bindemittelklassen können zur Anwendung kommen.

Die Dicke der Reproduktionsschicht kann sich im Bereich von etwa 0,1 bis etwa 100 $\mu$m oder darüber bewegen.

In den Fällen, in denen die durch additive Korrektur aufgebauten Reproduktionsschichten als strahlungsempfindliche Verbindungen solche enthalten, die ein negativ-arbeitendes System ergeben, empfiehlt sich die vollflächige Nachbelichtung oder Nacherhitzung des flächigen Materials nach der additiven Korrektur von der Seite der Reproduktionsschicht her; bei positiv-arbeitendem System braucht keine spezielle Nachbelichtung durchgeführt zu werden.

Um gegebenenfalls noch höhere Druckauflagen zu erzielen, ist nach Durchführung der erfindungsgemäßen Additivkorrektur zur Erhöhung der mechanischen und/oder chemischen Stabilität der Bildstellen ein "Einbrennen" möglich, d. h., eine thermische oder damit vergleichbare Nachbehandlung des flächigen Materials.

In den folgenden Beispielen und der vorstehenden Beschreibung sind die %-Angaben - wenn nicht eine andere Angabe vorliegt - auf das Gewicht bezogen. Gew.-Teile verhalten sich zu Vol.-Teilen wie g zu cm$^3$. Die zu behandelnden Reproduktionsschichten befinden sich auf leitfähigen Trägern, und diese werden - bei den Beispielen 1 bis 37 - als Kathode in einen Gleichstromkreis geschaltet, die nadelförmig ausgebildete Elektrode dann als Anode. In den Beispielen 38 bis 51 ist das zu bebildernde Substrat die Anode. Die Elektrolyttemperatur beträgt -wenn keine andere Angabe vorliegt - 25 bis 30 °C. Der Verlauf der Stromdichte kann in der Regel wie folgt dargestellt werden: Die Stromdichte steigt während einiger msec zunächst auf einen bestimmten Wert an, verbleibt einige msec auf diesem Stand und sinkt gegen Ende der elektrolytischen Entwicklung stark ab. Wenn keine speziellen Bemerkungen angegeben sind, sind die behandelten Materialien praxisgerecht. Bei höheren Spannungen ist darauf zu achten, daß die Platte auf Masse liegt, da es sonst zu gefährlichen Stromschlägen kommen kann.

Beispiele

Die mit dem erfindungsgemäßen Verfahren additiv korrigierten Platten sind in den folgenden Beispielen elektrochemisch aufgerauhte und anodisierte Aluminiumplatten. Es wurden die folgenden Elektrotauchlackierlösungen zur Additivkorrektur eingesetzt:

| A: | 200 g | Epoxidharz [R]Resydrol 16989 der Firma Hoechst AG (60 % in Ethylglykol) |
| | 2,75 g | Ameisensäure |
| | 797 ml | Wasser |
| B: | wie A, aber mit zusätzlich 33 g Härter SWX 596 | |
| C: | 200 g | Epoxidharz [R]Resydrol SWE 5186 |
| | 2,75 g | Ameisensäure |
| | 797 ml | Wasser |
| D: | 174 g | Epoxidharz [R]Resydrol SVK 5140 (69 %) |
| | 2,8 g | Ameisensäure |
| | 823 ml | Wasser |
| E: | 182 g | Epoxidharz [R]Resydrol SVK 5145 (66 %) |
| | 2,75 g | Ameisensäure |
| | 816 ml | Wasser |

6

Anodisch abscheidbare Harzlösungen

| F: | 133 g | Acrylatharz [R]Resydrol WY 323 (75 %) |
| | 26 g | Melaminharz [R]Maprenal MF 910 (90 %) |
| | 12 g | Diethanolamin |
| | 1250 ml | Wasser |
| G: | 133 g | Melaminharz [R]Resydrol WM 461 E |
| | 12 g | Diisopropanolamin |
| | 1000 ml | Wasser |
| H: | 171 g | Polybutadienharz [R]Resydrol SWP 195 E |
| | 17 g | 10%ige $NH_3$-Lösung |
| | 1000 ml | Wasser |
| I: | 200 g | Maleinsäureaddukt [R]Resydrol SWX 213 E |
| | 20 g | 10%ige $NH_3$-Lösung |
| | 1000 ml | Wasser |

Zur besseren Verankerung kann die Platte nach der Additivkorrektur noch thermisch (5 min, 100 °C) nachgehärtet werden.

Die Beispiele 1 bis 37 wurden als kataphoretische Lacke abgeschieden, die Beispiele 38 bis 51 anaphoretisch (Substrat als Anode).

7

Tabelle 1

| Bei-spiel Nr. | Art des Elektro-lyten | Spannung V | Zeit sec | Nachhär-tung | Qualität der Ab-scheidungs- und Farb-aufnahme |
|---|---|---|---|---|---|
| 1 | A | 10 | 1 | – | gut |
| 2 | A | 20 | 1 | – | sehr gut |
| 3 | A | 20 | 2,5 | – | sehr gut |
| 4 | A | 20 | 5 | – | sehr gut |
| 5 | A | 40 | 2,5 | – | sehr gut |
| 6 | A | 40 | 5 | – | sehr gut |
| 7 | A | 60 | 1 | – | sehr gut |
| 8 | A | 60 | 3 | – | sehr gut |
| 9 | A | 60 | 5 | – | sehr gut |
| 10 | A | 80 | 0,1 | – | sehr gut |
| 11 | A | 80 | 1 | – | sehr gut |
| 12 | A | 100 | 0,01 | – | sehr gut |
| 13 | A | 100 | 0,1 | – | sehr gut |
| 14 | A | 100 | 1 | – | sehr gut |
| 15 | A | 200 | 0,001 | – | sehr gut |
| 16 | A | 200 | 0,01 | – | sehr gut |
| 17 | A | 200 | 0,1 | – | sehr gut |
| 18 | A | 200 | 1 | – | sehr gut |
| 19 | B | 10 | 5 | – | sehr gut |
| 20 | B | 20 | 1 | – | sehr gut |
| 21 | B | 20 | 2,5 | – | sehr gut |
| 22 | B | 20 | 5 | – | sehr gut |
| 23 | B | 40 | 2,5 | – | sehr gut |
| 24 | B | 40 | 5 | – | sehr gut |

Tabelle 1 (Forsetzung)

| Bei-spiel Nr. | Art des Elektro-lyten | Spannung V | Zeit sec | Nachhär-tung | Qualität der Ab-scheidungs- und Farb-aufnahme |
|---|---|---|---|---|---|
| 25 | C | 20 | 5 | – | gut |
| 26 | C | 20 | 10 | – | gut |
| 27 | C | 40 | 2,5 | – | gut |
| 28 | C | 40 | 5 | – | gut |
| 29 | D | 10 | 1 | – | sehr gut |
| 30 | D | 10 | 10 | – | sehr gut |
| 31 | D | 20 | 10 | – | sehr gut |
| 32 | D | 40 | 1 | – | sehr gut |
| 33 | E | 10 | 1 | – | sehr gut |
| 34 | E | 20 | 15 | – | sehr gut |
| 35 | E | 30 | 20 | – | sehr gut |
| 36 | E | 40 | 10 | – | sehr gut |
| 37 | E | 40 | 15 | – | sehr gut |
| 38 | F | 40 | 30 | ja | sehr gut |
| 39 | G | 40 | 1 | ja | sehr gut |
| 40 | G | 40 | 5 | ja | sehr gut |
| 41 | G | 60 | 0,5 | ja | sehr gut |
| 42 | G | 60 | 1 | ja | sehr gut |
| 43 | G | 210 | 0,00 | ja | sehr gut |
| 44 | G | 210 | 0,01 | ja | sehr gut |
| 45 | G | 210 | 0,1 | ja | sehr gut |
| 46 | G | 210 | 1 | ja | sehr gut |
| 47 | H | 200 | 5 | ja | sehr gut |
| 48 | I | 20 | 15 | ja | gut |
| 49 | I | 30 | 15 | ja | sehr gut |
| 50 | I | 40 | 2 | ja | sehr gut |
| 51 | I | 80 | 1 | ja | sehr gut |

Beispiel 52

Die Harzlösung F wird mit 20 g eines Polykondensationsproduktes aus 1 mol 3-Methoxy-diphenylamin-4-diazoniumsulfat und 1 mol 4,4'-Bis-methoxymethyl-diphenylether, ausgefällt als Methylsulfonat, dispergiert und als Elektrotauchlack eingesetzt. In der so präparierten Lösung wird eine aufgerauhte und anodisierte Aluminiumplatte für 2 s bei 30 V anodisch geschaltet, und es resultiert eine bildmäßig beschichtete Platte, deren Beschichtung noch lichtempfindlich ist (negativ arbeitend) und einer Zweitstrukturierung durch normale Belichtung mit UV zugänglich ist.

9

# EP 0 294 611 B1

**Patentansprüche**

1. Verfahren zur selektiven Additivkorrektur von Fehlstellen einer auf einem elektrisch leitfähigen Substrat befindlichen bildmäßig verteilten Reproduktionsschicht durch Einwirkung von elektrischem Strom, dadurch gekennzeichnet, daß man zwischen dem Substrat und einer nadelförmigen, gegenüber der Fehlstelle angeordneten Elektrode eine Gleichspannung anlegt und auf die Fehlstelle eine elektrisch leitfähige wäßrige Lösung einer polymeren organischen Substanz aufbringt und daß man die polymere Substanz bei einer Stromdichte im Bereich von 0,01 bis 100 A/dm$^2$ an der Fehlstelle abscheidet.

2. Verfahren nach Anspruch 1, dadurch gekennzeichnet, daß die Konzentration der organischen Substanz 0,1 Gew.-% bis zur Sättigungsgrenze beträgt.

3. Verfahren nach Anspruch 2, dadurch gekennzeichnet, daß die Konzentration bis zu 20 Gew.-% beträgt.

4. Verfahren nach einem der Ansprüche 1 bis 3, dadurch gekennzeichnet, daß daß man die polymere Substanz über ein saugfähiges Material, vorzugsweise eine Membran, auf dem Substrat abscheidet.

5. Verfahren nach einem der Ansprüche 1 bis 4, dadurch gekennzeichnet, daß das Substrat aus Metall besteht.

6. Verfahren nach Anspruch 5, dadurch gekennzeichnet, daß das Metall Aluminium ist.

7. Verfahren nach Anspruch 6, dadurch gekennzeichnet, daß das Aluminium aufgerauht und/oder anodisiert ist.

8. Verfahren nach Anspruch 1, dadurch gekennzeichnet, daß die wäßrige Lösung zusätzlich eine strahlungsempfindliche Verbindung enthält, die mit der organischen Substanz abgeschieden wird.

9. Verfahren nach Anspruch 1, dadurch gekennzeichnet, daß der pH-Wert der wäßrigen Lösung im Bereich von 2 bis 10 liegt.

10. Verfahren nach Anspruch 1, dadurch gekennzeichnet, daß man die wäßrige Lösung in Gelform einsetzt.

**Claims**

1. Process for the selective additive correction of voids in a reproduction layer in image configuration situated on an electrically conductive substrate, under the action of electric current, wherein a direct current is applied between the substrate and a stylus-type electrode disposed opposite the void and an electrically conductive aqueous solution of a polymeric organic substance is aplied to the void and the polymeric substance is deposited in the void at a current density in the range from 0.01 to 100 A/dm$^2$.

2. A process as claimed in claim 1, wherein the concentration of the organic substance is 0.1% by weight up to the saturation limit.

3. A process as claimed in claim 2, wherein the concentration is up to 20% by weight.

4. A process as claimed in any of claims 1 to 3, wherein the polymeric substance is deposited on the substrate via an absorbent material, preferably a membrane.

5. A process as claimed in any of claims 1 to 4, wherein the substrate is made of a metal.

6. A process as claimed in claim 5, wherein the metal is aluminum.

7. A process as claimed in claim 6, wherein the aluminum has been grained and/or anodized.

8. A process as claimed in claim 1, wherein the aqueous solution additionally contains a radiation-sensitive compound which is deposited with the organic substance.

10

**9.** A process as claimed in claim 1, wherein the pH of the aqueous solution is in the range from 2 to 10.

**10.** A process as claimed in claim 1, wherein the aqueous solution is used in gel form.

**Revendications**

**1.** Procédé pour la correction additive sélective, sous l'effet du courant électrique, de défauts dans une couche de reproduction répartie selon l'image et se trouvant sur un substrat électroconducteur, caractérisé en ce qu'on applique un courant continu entre le substrat et une électrode en forme d'aiguille placée face au défaut, en ce qu'on dépose sur le défaut une solution aqueuse électroconductrice d'une substance organique polymère, et en ce qu'on fait précipiter la substance polymère sur le défaut, avec une densité de courant de l'ordre de 0,01 à 100 A/dm$^2$.

**2.** Procédé selon la revendication 1, caractérisé en ce que la concentration de la substance organique est comprise entre 0,1 % en poids et la limite de saturation.

**3.** Procédé selon la revendication 2, caractérisé en ce que ladite concentration peut atteindre 20 % en poids.

**4.** Procédé selon une des revendications 1 à 3, caractérisé en ce que la substance polymère se dépose sur le substrat par l'intermédiaire d'un matériau absorbant, de préférence une membrane.

**5.** Procédé selon une des revendications 1 à 4, caractérisé en ce que le substrat est constitué d'un métal.

**6.** Procédé selon la revendication 5, caractérisé en ce que le métal est l'aluminium.

**7.** Procédé selon la revendication 6, caractérisé en ce que l'aluminium est grainé et/ou oxydé anodiquement.

**8.** Procédé selon la revendication 1, caractérisé en ce que la solution aqueuse contient en outre un composé radiosensible qui se dépose avec la substance organique.

**9.** Procédé selon la revendication 1, caractérisé en ce que le pH de la solution aqueuse vaut de 2 à 10.

**10.** Procédé selon la revendication 1, caractérisé en ce que la solution aqueuse est utilisée sous forme de gel.

Fig. 1a

Fig. 1b

Fig. 1c